# EUROPEAN PATENT APPLICATION

(11) **EP 0 682 382 A2**
(43) Date of publication of application: **15.11.1995**
(21) Application number: 95302766.1
(22) Date of filing: 25.04.1995
(51) Int. Cl.: H01Q 9/04, H01Q 23/00

(54) **Microwave integrated tuned detector**

(30) Priority: 09.05.1994 US 239454
(71) Applicant: DISYS CORPORATION, Mississauga, Ontario L4W 5B2 (CA)
(72) Inventor: Oprea, Alexandru, Willowdale, Ontario M2J 1L9 (CA)
(74) Representative: Adams, William Gordon

(57) **Abstract**

A microwave detector, which integrates two circular patch antennas with a detector diode. The high impedance at the edge of the circular patch antenna is combined with 180° out of phase electric fields at diametrically opposite points, so as to match to the RF impedance of a zero or small DC bias diode. The result is a very simple, high-sensitivity narrow-band microwave integrated detector.

## Description

### Field of the Invention

This invention relates in general to microwave tuned detector-receivers, and more particularly to a low-cost, high-sensitivity microwave tuned receiver which integrates at least two circular patch antennas with a detector diode.

### Background of the Invention

Traditional microwave detector designs use resistive terminations to match an RF source. However, the detector diodes used in such designs, when operated unbiased or at a small DC bias, have a relatively high RF resistance and receive only a small fraction of the available signal power when connected in parallel to the resistive termination (e.g. a 50 ohm resistor).

In narrow band applications, high sensitivity tuned detectors are preferred. Impedance transformation and reverse-phasing of the detector diode terminals have been used to increase the sensitivity and output voltage of the resistive termination used in such prior art designs. Nevertheless, both techniques have deficiencies. The first technique makes use of circuit elements such as quarter-wave high impedance transmission lines, which are difficult to achieve with conventional lines. The second technique requires a 180° power divider. The requirement for additional elements to implement these two prior art techniques increases the complexity and size of the detector assembly and introduces extra losses.

### Summary of the Invention

In accordance with the present invention, two closely separated circular patch antennae are provided for receiving the microwave signal. A detector diode is placed in between the two antennae and is connected to their respective adjacent edges. The centre of one antenna is grounded to provide the DC return path for the diode. The centre of the second antenna provides the DC output of the detector.

The integrated tuned detector embodying the present invention takes advantage of both prior art techniques without requiring the use of additional elements. The result is a very simple, high-sensitivity integrated tuned detector.

The detector of the present invention has the following improvements over prior art tuned detectors:
(1) It combines the input power from two antennae resulting in a 6dB increase in output voltage.
(2) It provides a certain degree (depending on antenna separation) of spatial diversity;
(3) It does not need circuit elements to filter out the high frequency component at the output of the detector;
(4) It does not need circuit elements to provide a DC path for the diode.

Further advances of the microwave detector embodying the invention will be more fully understood from a consideration of the following detailed description in conjunction with the accompanying drawings.

### Brief Description of the Drawings

In the drawings:
Figure 1 is an equivalent functional diagram of a high-sensitivity integrated tuned detector according to well known design;
Figure 2 shows an implementation on microstrip of an integrated tuned detector according to the present invention;
Figure 3 is a cross-section through the lines III-III in Figure 2; and
Figure 4 shows an alternative embodiment in which circuitry for performing polarization diversity has been added.

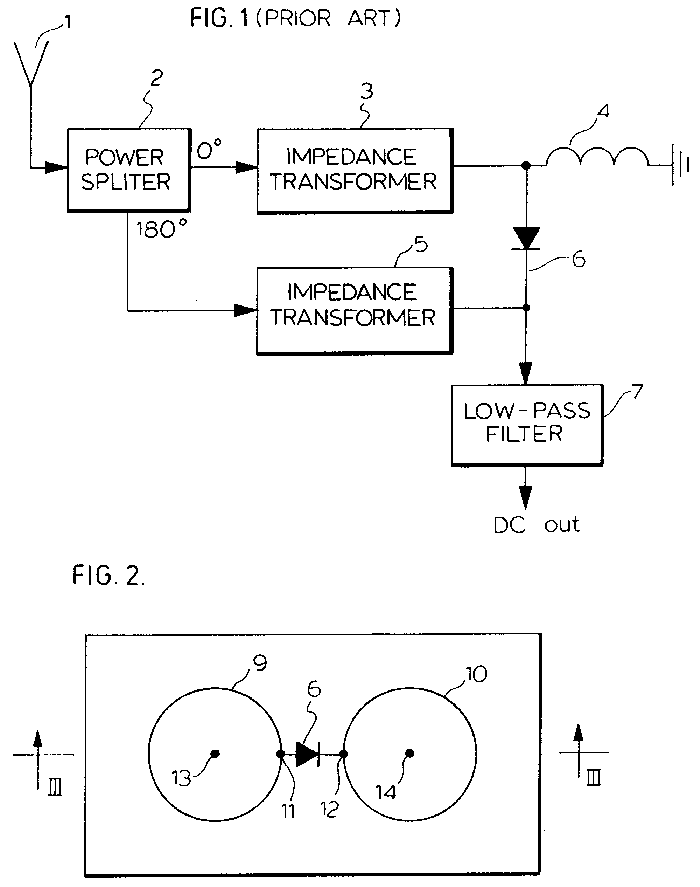

Figure 1 shows the equivalent functional diagram of a high-sensitivity integrated detector. The antenna 1 receives the microwave signal. The power spliter 2 divides the input power evenly and applies it to the impedance transformers 3 and 5, with a 180° phase difference. The impedance transformer 3 raises the impedance to as high a value as is practical and feeds the anode of a Schottky barrier detector diode 6. The impedance transformer 5 provides the same function as the impedance transformer 3 and supplies the cathode of the diode 6. The high frequency component of the detected signal is removed by low-pass filter 7. The inductor 4 provides the DC return path for the diode 6.

These functions may be implemented very simply through the exploitation of well known patch antenna technology.

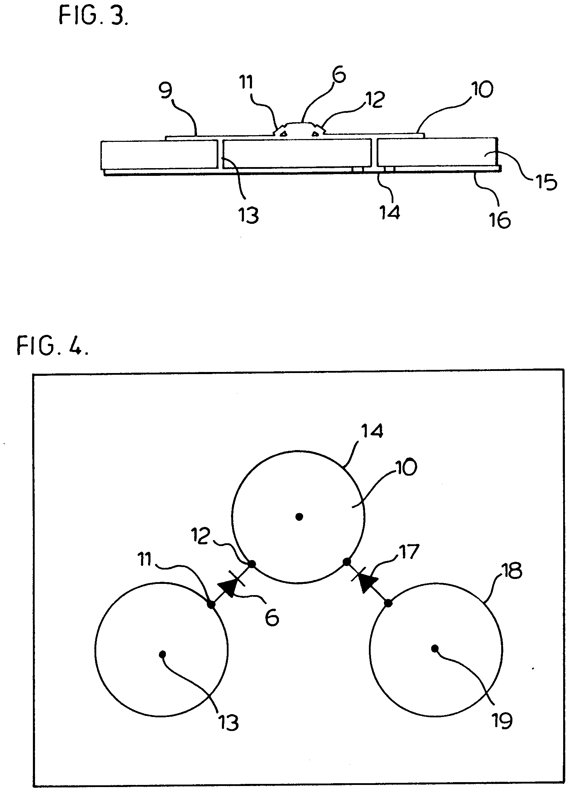

Figures 2 and 3 show an implementation on microstrip of these functional blocks according to the present invention.

A pair of circular patch antennae 9 and 10 are disposed on a substrate 15, having a ground plane 16 on the opposite side from the antenna patches 9 and 10. The radius of both circular patch antennae 9 and 10 is calculated to excite the dominant TM₁₁ mode at any frequency of interest. For this mode, the electrical field is zero at the centre of the patch. However, at diametrically opposite points on the circumference of the patch the electric fields are 180° out of phase. In addition, the impedance at the edge of each patch is very high (i.e. hundreds of ohms.). Further exploiting this knowledge, it is clear that the signals at points 11 and 12 are 180° out of phase (functional block 2 in Figure 1). Furthermore, because of the high impedance at points 11 and 12, impedance transformation (functional blocks 3 and 5 in Figure 1) is performed by the antennae themselves.

The electrical field is zero at the centre point 13 of the antenna 9 and therefore it can be grounded to provide the DC return path for the diode 6 (the function of the inductor 4 in Figure 1).

The DC output signal is present at point 14. Because the field is zero at this point as well, low-pass filtration (block 7 in Figure 1) is performed by antenna 10. The DC return point 13 and DC output point 14 can be interchanged, thereby producing a DC output with reverse polarity.

Accordingly, the configuration of the present invention results in a high-sensitivity integrated tuned detector utilizing only three elements.

Alternative variations are possible. In Figure 4 an example of an integrated tuned detector is shown with polarization diversity. The configuration is essentially a combination of two orthogonal integrated tuned detectors in accordance with the present invention (i.e. by including an additional circular patch antenna 18 with grounded centre 19, and connected to antenna 10 via an additional diode 17). The two detectors of Figure 4 share the antenna 10, which also acts as diversity combiner.

All such alternative variations are believed to be within the sphere and scope of the present invention as defined by the claims appended hereto.

## Claims

1. A microwave integrated tuned detector for receiving microwave signals in a predetermined frequency range, comprising:
a) a DC output;
b) a substrate;
c) a grounded plane mounted on one side of said substrate;
d) at least two circular patch antennae mounted on an opposite side of said substrate from said grounded plane, said antennae being of predetermined radius for exciting a dominant TM₁₁ mode in said predetermined frequency range;
e) a detector diode having one terminal thereof connected to one of said at least two circular patch antennae, and having an opposite terminal thereof connected to the other of said at least two circular patch antennae;
f) a centre point of said one of said at least two circular patch antennae being connected to said grounded plane for providing a DC return path for said detector diode; and
g) a centre point of said other one of said at least two circular patch antennae being connected to said DC output.

2. The microwave integrated tuned detector of claim 1, wherein said detector diode is a Schottky diode.

3. The microwave integrated tuned detector of claim 2, wherein said Schottky diode is unbiased.

4. The microwave integrated tuned detector of claim 2, wherein said Schottky diode is biased at a small DC current.

5. The microwave integrated tuned detector of claim 1, wherein said detector diode is connected to respective edges of said at least two circular patch antennae.
